# EUROPÄISCHE PATENTSCHRIFT

(11) **EP 0 559 247 B1**
(45) Veröffentlichungstag und Bekanntmachung des Hinweises auf die Patenterteilung: **06.08.1997**
(21) Anmeldenummer: 93200256.1
(22) Anmeldetag: 02.02.1993
(51) Int. Cl.: H03F 3/68

(54) **Tonsignal-Verstärker**
Audio amplifier
Amplificateur audio

(30) Priorität: 06.02.1992 DE 4203353
(43) Veröffentlichungstag der Anmeldung: 08.09.1993
(73) Patentinhaber: Philips Patentverwaltung GmbH, 22335 Hamburg (DE); Philips Electronics N.V., 5621 BA Eindhoven (NL)
(72) Erfinder: Dünnebacke, Joachim, c/o Philips Patentverwaltung, W-2000 Hamburg 1 (DE)
(74) Vertreter: von Laue, Hanns-Ulrich, Dipl.-Ing.

(56) Entgegenhaltungen:
- EP-A- 0 310 575
- GB-A- 2 099 664
- PATENT ABSTRACTS OF JAPAN vol. 13, no. 99 (E-724)(3447) 8. März 1989 & JP-A-63 272 208
- PATENT ABSTRACTS OF JAPAN vol. 11, no. 245 (E-531)(2692) 11. August 1987 & JP-A-62 059 406

## Beschreibung

Die Erfindung betrifft einen Verstärker für Tonsginale mit einer geradzahligen Anzahl von Leistungsverstärkern mit je einem Ausgang, wobei jeder Verstärkerausgang auf einen ersten Anschluß eines jeweils zugeordneten Lautsprechers schaltbar ist und wobei zweite Anschlüsse der Lautsprecher auf den Ausgang eines Puffer-Verstärkers schaltbar sind.

Ein derartiger Verstärker mit zwei Leistungsverstärkern ist aus der japanischen Patentanmeldung JPA-63-272208 bekannt. Dort arbeiten die Ausgänge zweier invertierender Leistungs- verstärker über je einen Lautsprecher gemeinsam auf einen Ausgang eines Pufferverstärkers. Der Puffer-Verstärker liefert an seinem Ausgang eine Gleichspannung, die etwa den halben Wert der Versorgungsspannung aufweist. Diese Schaltungsanordnung weist den Nachteil auf, daß die Ströme, die durch die beiden Lautsprecher fließen, sich gleichsinnig übertragen, so daß durch den Pufferverstärker die Summe der Ströme fließt.

Es ist Aufgabe der Erfindung, eine Verstärkerschaltung zu schaffen, die mit geringerer Verlustleistung arbeitet.

Diese Aufgabe wird erfindungsgemäß dadurch gelöst, daß der Puffer-Verstärker an seinem Ausgang eine Gleichspannung liefert, die etwa den halben Wert der Versorgungsspannung der Leistungsverstärker aufweist und daß für jedes Tonsignal die Hälfte der Leistungsverstärker ein gegenüber ihrem Eingangssignal invertiertes Ausgangssignal liefert.

Durch diese Auslegung der Leistungsverstärker wird erreicht, daß jeweils zwei Leistungsverstärker ein Ausgangssignal entgegengesetzter Polarität liefern, so daß durch den Pufferverstärker nicht die Summe der Ströme fließt, sondern die Differenz der Ströme. Sind die Signale, die

durch die beiden Leistungsverstärker fließen gleich, z.B. weil beide Verstärker an den gleichen Tonkanal angeschlossen sind, so heben sich die Ströme auf, und durch den Puffer-Verstärker fließt kein Strom. Selbst wenn die beiden korrespondierenden Verstärker an verschiedenen Tonkanälen angeschlossen sind, wird in den meisten Fällen der durch den Puffer-Verstärker fließende Strom gering sein, da die Information beispielsweise beider Tonkanäle eines Stereo-Tonsignals häufig sehr ähnlich oder weitgehend identisch sind. Damit die durch die Lautsprecher fließenden Ströme sich in dieser Weise aufheben oder nahezu aufheben können, muß die Gleichspannung, die der Pufferverstärker an seinem Ausgang liefert, dem halben Wert der Versorgungsspannung der Leistungsverstärker entsprechen.

Eine weitere Voraussetzung ist selbstverständlich, daß die einzelnen Leistungsverstärker die gleiche Leistungsverstärkung aufweisen, wobei jedoch einige invertierend und einige nicht-invertierend arbeiten. Die Anzahl der invertierenden und nicht-invertierend arbeitenden Leistungsverstärker ist gleich.

Durch diese Auslegung der Leistungsverstärker bzw. des Verstärkers insgesamt wird erreicht, daß durch den Puffer-Verstärker nur ein sehr geringer Strom fließt, der in vielen Fällen Null ist. Auf diese Weise wird die Verlustleistung des Verstärkers deutlich verringert.

Insbesondere für Anwendungen in Fahrzeugen für Autoradios soll ein Stereo-Tonsignal in vielen Fällen über vier Verstärkerstufen verstärkt werden, denen jeweils ein Lautsprecher nachgeschaltet ist. Insbesondere für diesen Anwendungszweck ist nach einer vorteilhaften Ausgestaltung vorgesehen, daß jedem Tonkanal je ein invertierender und je ein nicht-invertierender Leistungsverstärker zugeordnet ist.

Bei dieser Konstellation ist genau der Fall erreicht, daß sich die Ströme zweier Leistungsverstärker bzw. die entsprechenden durch die zugeordneten Lautsprecher fließenden Ströme gegenseitig aufheben. Je Tonkanal ist ein invertierender und ein nicht-invertierender Leistungsverstärker vorgesehen, die beide das gleiche Ausgangssignal, jedoch mit entgegengesetzter Polarität erzeugen. Somit ist die Summe der durch die Lautsprecher fließenden Signale gleich Null, so daß durch den Puffer-Verstärker kein Strom fließt. Da dies für beide Tonkanäle gilt, fließt durch den Puffer-Verstärker kein oder nahezu kein Strom, so daß dort auch keine Verlustleistung entsteht.

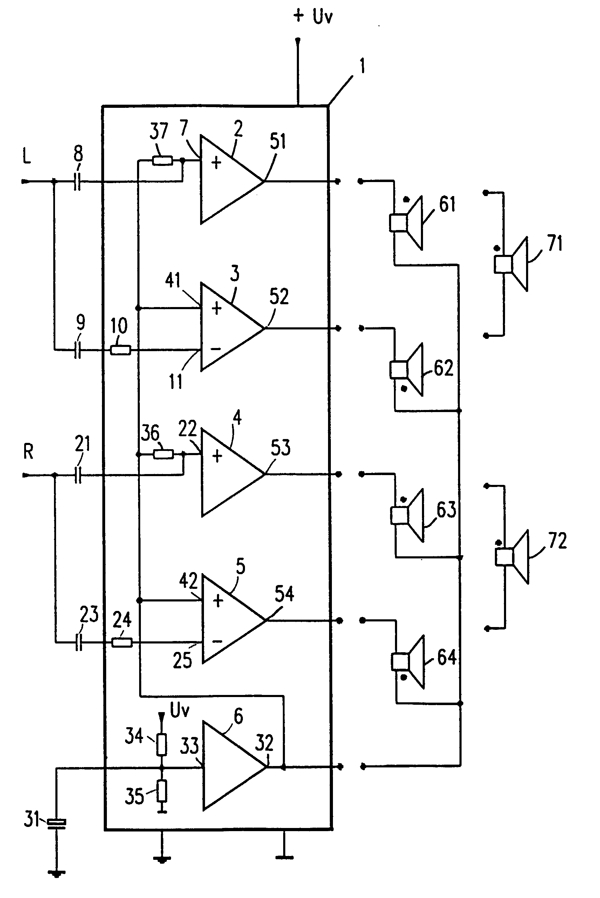

Anhand der Zeichnung wird ein Ausführungsbeispiel der Erfindung näher erläutert.

Die einzige Fig. zeigt die schematische Darstellung eines Verstärkers 1, welcher vier Leistungsverstärker 2, 3, 4 und 5 aufweist. Es ist ferner ein Puffer-Verstärker 6 vorgesehen. Dem Verstärker wird von außen eine Versorgungsspannung Uᵥ zugeführt.

Der Verstärker 1 ist dazu vorgesehen, ein extern zugeführtes Stereo-Tonsignal zu verstärken. In der Darstellung gemäß der Zeichnung ist ein Tonsignal mit L und das andere Tonsignal mit R bezeichnet. Hierbei steht L für den linken Tonkanal und R für den rechten Tonkanal.

In dem in der Fig. dargestellten Ausführungsbeispiel sind die beiden Leistungsverstärker 2 und 3 dazu vorgesehen, das Tonsignal L zu verstärken. Zur Minimierung der Verlustleistung wird dieses Tonsignal L einem nicht-invertierenden Eingang 7 des Leistungsverstärkers 2 zugeführt, wobei extern ein Koppelkondensator 8 zwischengeschaltet ist. Das Tonsignal L wird ferner über einen Koppelkondensator 9 und einen Anpassungswiderstand 10 auf einen invertierenden Eingang 11 des Leistungsverstärkers 3 geführt.

In entsprechender Weise gelangt das Tonsignal des anderen Kanals R über einen Koppelkondensator 21 auf einen nicht-invertierenden Eingang 22 des Leistungsverstärkers 4 sowie über einen Koppelkondensator 23 und einen Widerstand 24 auf einen invertierenden Eingang 25 des Leistungsverstärkers 5.

Der Puffer-Verstärker 6 ist eingangsseitig über eine Kapazität 31 auf Masse geschaltet. Über diese Kapazität 31 können Wechselspannungen, die an einem Ausgang 32 des Puffer-Verstärkers 6 auftreten, abgeleitet werden. Der Eingang 33 des Puffer-Verstärkers 6 ist ferner über einen Widerstand 34 auf die positive Versorgungsspannung Uᵥ geschaltet. Der Eingang 33 ist ferner über einen weiteren Widerstand 35 auf Massepotential gelegt. Die Werte der Widerstände 34 und 35 sind identisch, so daß der Verstärker 6 an seinem Ausgang 32 eine Gleichspannung liefert, die den halben Wert der Versorgungsspannung Uᵥ aufweist.

Die am Ausgang 32 des Puffer-Verstärkers 6 auftretende Gleichspannung wird den Leistungsverstärkern 2 und 4 an ihren nicht-invertierenden Eingängen 7 bzw. 22 über je einen Widerstand 36 bzw. 37 zugeführt.

Die bezüglich der Tonsignale invertierend arbeitenden Leistungsverstärker 3 und 5 weisen je einen nicht-invertierenden Eingang 41 bzw. 42 auf. Auf diese Eingänge 41 bzw. 42 ist ebenfalls das Gleichspannungssignal vom Ausgang 32 des Puffer-Verstärkers 6 geführt.

Der Leistungsverstärker 2 liefert an seinem Ausgang 51 das ihm zugeführte Tonsignal L in verstärkter, nicht-invertierter Form. Der Leistungsverstärker 3 liefert das gleiche Tonsignal L im gleichen Maße verstärkt, jedoch in nicht-invertierter Form an seinem Ausgang 52. In entsprechender Weise liefert der Leistungsverstärker 4 an seinem Ausgang 53 das Tonsignal R in nicht-invertierter und der Leistungsverstärker 5 an seinem Ausgang 54 das Tonsignal R in invertierter Form. An den Ausgang 51 des Leistungsverstärkers 2 ist ein Lautsprecher 61 schaltbar, welcher mit seinem ersten Anschluß an diesen Ausgang 51 und mit seinem zweiten Anschluß an den Ausgang 32 des Puffer-Verstärkers 6 geschaltet wird. In entsprechender Weise ist ein weiterer Lautsprecher 62 vorgesehen, der mit seinem ersten Anschluß an den Ausgang 52 des Leistungsverstärkers 3 und mit seinem zweiten Anschluß ebenfalls an den Ausgang 32 des Puffer-Verstärkers 6 schaltbar ist.

Für den rechten Tonkanal ein identischer Aufbau vorgesehen, zwei Lautsprecher 62 bzw. 64 sind mit ihren ersten Anschlüssen an die Ausgänge 53 bzw. 54 der Leistungsverstärker 4 bzw. 5 und mit ihren zweiten Anschlüssen an den Ausgang 32 des Puffer-Verstärkers 6 angeschlossen.

Durch den Lautsprecher 61 fließt der gleiche Strom wie durch den Lautsprecher 62, jedoch haben die Ströme entgegengesetzte Polarität, so daß diese Ströme sich an den zweiten Anschlüssen bzw. an der Zusammenführung auf den Ausgang 32 des Puffer-Verstärkers 6 aufheben. Entsprechendes gilt für die durch die Lautsprecher 63 und 64 fließenden Ströme, die gleiche Größe jedoch entgegengesetzte Richtung haben und sich ebenfalls durch die Zusammenschaltung am Ausgang 32 des Puffer-Verstärkers 6 aufheben. Es wird hierdurch eine geringe Verlustleistung erzielt.

Aus akustischen Gründen kann gegebenenfalls berücksichtigt werden, daß die Ströme durch die beiden Lautsprecher eines Tonkanals in entgegengesetzter Richtung fließen, so daß je nach Anordnung der Lautsprecher beispielsweise in einem Fahrzeug die beiden Lautsprecher umgekehrt gepolt werden können. In der Zeichnung ist dies durch die im Bereich der Anschlüsse der Lautsprecher angedeuteten Punkte markiert.

Auch für den Fall, daß die Leistungsverstärker 2 und 3 bzw. 4 und 5 etwas unterschiedliche Verstärkungsfaktoren aufweisen, oder daß die Lautsprecher 61 und 62 bzw. 63 und 64 differierende Werte aufweisen, ist der durch den Puffer-Verstärker 6 abgeführte Strom relativ gering.

Der in der Fig. dargestellte Verstärker 1 ist auch dazu geeignet, als Verstärker mit Brückenschaltung nur zwei Lautsprecher zu versorgen. In der Fig. ist dies angedeutet durch je einen Lautsprecher 71 bzw. 72 für die Tonkanäle. Soll der Verstärker 1 als Brückenverstärker genutzt werden, so wird der Lautsprecher 71 mit seinen Anschlüssen an die Ausgänge 51 und 52 der Leistungsverstärker 2 und 3 geschaltet. Die Verstärker 2 und 3 arbeiten dann als Brücken-Verstärkerschaltung. In entsprechender Weise ist der Lautsprecher 72 an die Ausgänge 53 und 54 der Leistungsverstärker 4 und 5 schaltbar.

## Patentansprüche

1. Verstärker (1) für Tonsignale mit einer geradzahligen Anzahl von Leistungsverstärkern (2, 3, 4, 5) mit je einem Ausgang (51, 52, 53, 54), wobei jeder Verstärkerausgang (51, 52, 53, 54) auf einen ersten Anschluß eines jeweils zugeordneten Lautsprechers (61, 62, 63, 64) schaltbar ist und wobei zweite Anschlüsse der Lautsprecher (61, 62, 63, 64) auf den Ausgang (32) eines Puffer-Verstärkers (6) schaltbar sind, wobei
der Puffer-Verstärker (6) an seinem Ausgang (32) eine Gleichspannung liefert, die etwa den halben Wert der Versorgungsspannung der Leistungsverstärker (3, 5) aufweist und für jedes Tonsignal daß die Hälfte der Leistungsverstärker ein gegenüber ihrem Eingangssignal invertiertes Ausgangssignal liefert.

2. Verstärker nach Anspruch 1 für ein Stereo-Tonsignal,
dadurch gekennzeichnet, daß jedem Tonkanal je ein invertierender (3, 5) und je ein nicht-invertierender (2, 4) Leistungsverstärker zugeordnet ist.

## Claims

1. Amplifier (1) for audio signals, comprising an even number of power amplifiers (2, 3, 4, 5) which have each an output (51, 52, 53, 54), in which each amplifier output (51, 52, 53, 54) can be switched to a first terminal of an associated loudspeaker (61, 62, 63, 64) and in which second terminals of the loudspeakers (61, 62, 63, 64) can be switched to the output (32) of a buffer amplifier (6), the buffer amplifier (6) producing on its output (32) a DC voltage which is about half the value of the supply voltage of the power amplifiers (3, 5) and for each audio signal half the power amplifiers producing an output signal that is inverted relative to their input signal.

2. Amplifier as claimed in Claim 1 for a stereo audio signal, characterized in that an inverting (3, 5) and a non-inverting (2, 4) power amplifier is assigned to each audio signal.

## Revendications

1. Amplificateur (1) pour les signaux audio avec un nombre pair d'amplificateurs de puissance (2, 3, 4, 5) ayant respectivement une sortie (51, 52, 53, 54), chaque sortie d'amplificateur (51, 52, 53, 54) pouvant être montée sur une première connexion d'un haut-parleur qui lui est respectivement affecté (61, 62, 63, 64) et les deuxièmes connexions des haut-parleurs (61, 62, 63, 64) pouvant être montées sur la sortie (32) d'un amplificateur tampon, l'amplificateur tampon (6) produisant à sa sortie (32) une tension continue qui présente environ la moitié de la tension d'alimentation de l'amplificateur de puissance (3, 5) et, pour chaque signal audio, la moitié des amplificateurs de puissance produisant un signal de sortie inversé par rapport à son signal d'entrée.

2. Amplificateur selon la revendication 1 pour un signal audio stéréo, caractérisé en ce qu'à chaque signal audio sont respectivement affectés un amplificateur de puissance inverseur (3,5) et un amplificateur de puissance non inverseur (2, 4).
